# EUROPÄISCHE PATENTSCHRIFT

(11) **EP 3 323 017 B1**
(45) Veröffentlichungstag und Bekanntmachung des Hinweises auf die Patenterteilung: **10.04.2019**
(21) Anmeldenummer: 16739108.5
(22) Anmeldetag: 14.07.2016
(51) Int. Cl.: G03F 1/68, G03F 7/20

(54) **LASERABLATIERBARER MASKENFILM**
LASER ABLATABLE MASKING FILM
FILM DE MASQUAGE POUVANT ETRE SOUMIS A UNE ABLATION LASER

(30) Priorität: 15.07.2015 EP 15176893
(43) Veröffentlichungstag der Anmeldung: 23.05.2018
(73) Patentinhaber: Flint Group Germany GmbH, 70469 Stuttgart (DE)
(72) Erfinder: MÜHLFEIT, Markus, 71263 Weil der Stadt (DE); LEINENBACH, Alfred, 77704 Oberkirch-Nußbach (DE); UNGLAUBE, Jochen, 79341 Kenzingen (DE)
(74) Vertreter: Schuck, Alexander
(86) Internationale Anmeldenummer: PCT/EP2016/066728
(87) Internationale Veröffentlichungsnummer: WO 2017/009410

(56) Entgegenhaltungen:
- EP-A1- 2 416 217
- EP-A2- 2 047 987
- WO-A1-97/42547

## Beschreibung

Die Erfindung betrifft einen laserablatierbaren Maskenfilm für die Belichtung von Reliefdruckplatten und Siebdruckschablonen sowie dessen Verwendung.

Maskenfilme werden für lithographische Verfahren, beispielsweise zur Herstellung von Druckplatten, Siebdruckformen, gedruckten Leiterbahnen, Halbleitern und in einer Vielzahl von anderen graphischen Prozessen, z.B. als einfache Korrekturfilme, benötigt. Während früher photographische Filme, basierend auf der bildmäßigen Reduktion von Silbersalzen, verwendet wurden, kommen heute zunehmend digital bebilderbare, d.h. mittels Laser bebilderbare Maskenfilme zum Einsatz.

Beispielsweise werden zur Belichtung von photopolymeren Reliefdruckplatten, wie Flexo- oder Buchdruck- oder Tiefdruckplatten oder Siebdruckschablonen, Maskenfilme verwendet. Der Maskenfilm wird mittels eines Lasers bebildert. Dabei werden die zu belichtenden Bereiche durch Laserablation entfernt. Anschließend wird der bebilderte Maskenfilm auf eine photopolymere Druckplatte aufgelegt und mittels Vakuum in innigem Kontakt mit der zu belichtenden Druckplatte gebracht. Alternativ kann der Maskenfilm auf die Druckplatte auch durch Anwendung von Druck oder erhöhter Temperatur auflaminiert werden. Anschließend wird die photopolymere Druckplatte durch den Maskenfilm flächig mit UVA-Licht belichtet. Bei der Belichtung härten die belichteten Bereiche der Druckplatte und werden dabei in Lösungsmitteln unlöslich. Die unbelichteten Bereiche bleiben löslich und werden in einem folgenden Auswasch- oder Entwicklungsschritt entfernt. Dabei entsteht das gewünschte Druckrelief.

Es versteht sich von selbst, dass der Maskenfilm eine hohe Auflösung besitzen sollte und eine hohe optische Dichte im Bereich von UVA-Licht haben sollte. Für vernetzende Reliefdruckplatten sollte die optische Dichte des Maskenfilmes im Bereich von 350 bis 400 nm mindesten 2,5 - 3 betragen. Die ablatierten Bereiche des Maskenfilms sollten dagegen für UVA-Licht möglichst transparent sein. Die optische Dichte (ODₘᵢₙ) sollte hier kleiner als 0,1 sein. Des Weiteren sollte der Maskenfilm einen guten Kontakt zu der Oberfläche der Reliefdruckplatte ausbilden, um Kopierfehler zu vermeiden, und nach der flächigen UVA-Belichtung ohne großen Kraftaufwand wieder abgezogen werden können. Bei der Belichtung sollten keine Bestandteile aus dem Maskenfilm in die reliefbildende Schicht migrieren. Aus Kostengründen sollte der Maskenfilm einfach hergestellt werden können und wiederverwendbar sein.

Ein Maskenfilm besitzt mindestens eine laserablatierbare Schicht und ein für UV-Licht transparentes Trägermaterial. Als Trägermaterial können beispielsweise transparente Polyesterfolien verwendet werden.

Die Ablation des Maskenfilms kann mittels verschiedener Laser vorgenommen werden. Laser, die Licht im nahen IR-Wellenlängenbereich emittieren, werden bevorzugt eingesetzt. Hierzu zählen beispielsweise IR-Laserdioden (830 nm) oder Nd-YAG-Festkörper- oder Faserlaser (1064 bzw. 1100 nm).

Eine Voraussetzung für die effektive Bebilderung eines Maskenfilms durch Ablation ist die Absorption des Laserstrahls. Feinverteilter Ruß ist beispielsweise ein sehr guter Absorber im nahen IR-Bereich. Alternativ zu Ruß können auch IR-absorbierende Farbstoffe in den Maskenfilmen eingesetzt werden.

US 5,998,088 beschreibt beispielsweise ein laserablatierbares Maskenmaterial, das aus Polycyanoacrylat als polymerem Bindemittel und IR-absorbierenden Farbstoffen besteht. Das thermisch labile Polycyanoacrylat gibt dem Maskenfilm eine gute Laserempfindlichkeit.

US 6,001,530 beschreibt laserablatierbare Maskenmaterialien, die als farbgebende Komponenten im Thermotransferdruck verwendet werden. Die laserablatierbare Schicht besteht aus einer Kombination aus Ruß und löslichen, schwarzen Farbstoffen.

US 6,828,067 beschreibt laserablatierbare Maskenfilme, die neben Ruß noch zusätzlich UV-absorbierende Farbstoffe enthalten. So kann eine geringere Schichtdicke realisiert werden und die Filme zeigen eine hohe Auflösung und Empfindlichkeit.

EP 0562952 B1 beschreibt laserablatierbare Maskenmaterialien aus einem Azidgruppen-haltigen Polymer und IR-absorbierenden Farbstoffen. Die Masken haben wiederum eine gute Laserempfindlichkeit.

US 8,632,944 beschreibt einen mehrschichtigen Maskenfilm, der unterschiedliche IR- und UV-absorbierende Substanzen enthält. Als polymere Bindemittel der einzelnen Schichten werden Nitrocellulose und Polycyanoacrylate eingesetzt, die dem Maskenfilm eine hohe Laserempfindlichkeit verleihen. Durch den mehrschichtigen Aufbau ist der Maskenfilm teuer in der Herstellung.

Einen einfacheren Aufbau beschreibt US 8,945,813. Hier enthält die Maske nur wenige Einzelschichten. Die Laserempfindlichkeit wird aber auch hier durch IR-absorbierende Farbstoffe erreicht. Ferner werden niedermolekulare UV-Absorber eingesetzt.

Alle genannten Maskenfilme enthalten niedermolekulare Komponenten wie beispielsweise lösliche IR-Farbstoffe oder UV-Absorber, die bei der Belichtung mit UVA-Licht in die zu belichtende Reliefdruckplatte migrieren können. Findet diese Migration statt, verändern sich die Eigenschaftsprofile sowohl des Maskenfilms als auch der Druckplatte. Nach dem Kontaktieren der Maske mit der Druckplatte muss die Belichtung daher unverzüglich durchgeführt werden, um diese Migrationseffekte zu minimieren. Eine Wiederverwendung des Maskenfilms - d.h. ein mehrmaliges Belichten durch dieselbe Maske hindurch - ist daher nicht möglich.

Ferner enthalten die genannten Maskenfilme teure Inhaltsstoffe wie IR-Absorber, UV-Absorber oder spezielle Bindemittel wie Nitrocellulose, Azidgruppen-haltige Polymere oder Polycyanoacrylate, oder die Maskenfilme sind vielschichtig aufgebaut, was die Herstellkosten weiter erhöht.

EP2416217 A1 und WO97/42547 beschreiben einen Maskenfilm und EP2047987 offenbart eine lasergravierbare Schicht, die PVA-Derivate enthält.

Es besteht also ein kommerzielles Interesse an einem laserablatierbaren Maskenfilm, der eine gute Laserempfindlichkeit hat, der kostengünstig hergestellt werden kann und mit dem photopolymere Druckplatten (Flexo-, Buchdruck- oder Tiefdruckplatten und Siebdruckformen) sicher verarbeitet werden können, wobei insbesondere das mehrmalige Belichten mit ein- und derselben Maske problemlos möglich sein sollte. Da die meisten Verarbeiter von Reliefdruckplatten heute nicht mehr über Anlagen zur Herstellung photographischer Silberfilme verfügen, besteht ferner ein Bedarf an einem einfachen, kostengünstigen laserablatierbaren Maskenfilm, der als Korrekturfilm ausgegeben und überprüft werden kann, bevor mit der eigentlichen Druckplattenverarbeitung begonnen wird. Bevor eine teure digitale Flexoplatte bebildert (gelasert) wird, lasert man so einen preiswerteren Maskenfilm und überprüft daran, ob alle Elemente korrekt platziert und wiedergegeben sind.

Gelöst wird die Aufgabe durch einen laserablatierbaren Maskenfilm für die Belichtung von Reliefdruckplatten und Siebdruckschablonen umfassend mindestens
(i) eine dimensionsstabile Trägerfolie,
(ii) eine UV-transparente Haftschicht und
(iii) eine laserablatierbare Maskenschicht,
dadurch gekennzeichnet, dass die laserablatierbare Maskenschicht (iii)
a) ein Bindemittel enthaltend einen vernetzten Polyvinylalkohol,
b) ein UV/VIS-Licht und IR-Licht absorbierendes Material und
c) optional einen anorganischen Füllstoff
enthält.

Als dimensionsstabiler Träger (i) sind Polyesterfolien bevorzugt, insbesondere Polyethylenterephthalat- (PET)-Folien. Gut geeignet sind PET-Folien mit einer Dicke von 50 µm bis 200 µm. Besonders bevorzugt sind 125 µm oder 175 µm dicke PET-Folien. Die Folien sollten eine mittlere Rauigkeit aufweisen. PET-Folien mit einer gemittelten Rautiefe zwischen 0,1 µm und 1 µm sind bevorzugt.

Die UV-transparente Haftschicht (ii) - auch als Primerschicht bezeichnet - hat zwei wesentliche Funktionen. Sie stellt die Haftung zu dem dimensionsstabilen Träger (i) her und sie schützt den Träger vor den bei der Laserablation auftretenden hohen Temperaturen, die zu einem Einbau von Rußteilchen oder anderen Verbrennungsprodukten in die Trägerfolie führen können, wodurch die UV-Transparenz der Bildbereiche des laserablatierten Maskenfilms verringert werden kann.

Die Haftschicht (ii) ist für UVA-Licht, d. h. Licht im Wellenlängenbereich von 300 - 400 nm, transparent. Die Durchlässigkeit für UVA-Licht sollte mindestens 50%, bevorzugt mindestens 80%, betragen.

Die Haftschicht (ii) enthält im Wesentlichen ein polymeres Bindemittel, das gegebenenfalls vernetzt sein kann, und optional noch einen oder mehrere Füllstoffe.

Als polymere Bindemittel d) gut geeignet sind beispielsweise Polyester, Polyetherester, Polyurethane und Polyesterurethane, die zu Polyesterfolien eine gute Haftung aufbauen können. Das polymere Bindemittel kann entweder als 1-Komponentensystem oder als vernetzendes 2-Komponentensystem mit geeigneten multifunktionellen Vernetzern aufgebracht werden. Besonders gut geeignete Bindemittel sind Polymere, im Allgemeinen Polyester oder Polyesterurethane mit OH-Gruppen, wie sie beispielsweise unter den Handelsnamen Desmocoll® und Desmophen® (Bayer) kommerziell verfügbar sind. Als Vernetzer e) hierfür sind insbesondere aliphatische multifunktionelle Isocyanate oder aromatische multifunktionelle Isocyanate oder Mischungen aus aliphatischen und aromatischen multifunktionellen Isocyanaten, wie sie beispielsweise unter dem Handelsnamen Desmodur® (Bayer) verfügbar sind, gut geeignet.

Wird ein vernetzendes 2-Komponentensystem eingesetzt, beträgt der Anteil des Vernetzers 5 bis 30 Gew.-%, bezogen auf alle Komponenten der Haftschicht (ii), bevorzugt beträgt dieser Anteil 10 bis 20 Gew.-%.

Zur Verbesserung der Klebfreiheit kann die Haftschicht (ii) optional einen mineralischen Füllstoff enthalten. Gut geeignet sind beispielsweise Siliciumdioxid, insbesondere Quarzmehle und Quarzpulver, Silikate, insbesondere Aluminiumsilikate, Silikatgläser oder Aluminiumoxide. Der Anteil des Füllstoffes in der Haftschicht (ii) kann 0 bis 30 Gew.-%, bevorzugt 0 bis 15 Gew.-% bezüglich aller Komponenten der Haftschicht (ii) betragen. Der Füllstoff fungiert in den Bildbereichen der laserablatierten Maskenschicht als eine Art Abstandshalter, wodurch sich ein guter Kontakt dieser Bereiche zur Druckplatte bei der UV-Belichtung ergibt und die Gefahr von Hohlkopien verringert wird. Der Film muss sich an die zu belichtende Flexoplatte anschmiegen, ohne zu kleben. Haftet er zu stark an der Druckplatte, bilden sich an manchen Stellen Lufteinschlüsse zwischen Film und Druckplatte. Bei der Belichtung wird das UV-Licht an der Luft gestreut, es bilden sich Kopierfehler oder Hohlkopien.

Die Haftschicht (ii) enthält im Allgemeinen
d) 70 bis 100 Gew.-% des polymeren Bindemittels,
e) 0 bis 30 Gew.-% des Vernetzers,
f) 0 bis 30 Gew.-% des anorganischen Füllstoffs.

Die Dicke der Haftschicht (ii) beträgt im Allgemeinen 0,1 µm bis 2 µm, bevorzugt 0,7 µm bis 1,5 µm. Ist die Haftschicht zu dünn, kann der Schutz vor der Einwirkung der Laserstrahlung ungenügend sein. Ist die Haftschicht zu dick, kann die Auflösung der Maskenschicht durch Streueffekte des UV-Lichtes beeinträchtigt werden.

Das wesentliche Element der vorliegenden Erfindung ist die Zusammensetzung der laserablatierbaren Maskenschicht (iii), die im Wesentlichen ein vernetztes Bindemittel auf Basis von Polyvinylalkohol und einen auf Kohlenstoff basierenden, migrationsstabilen Absorber für UV/VIS-Licht und IR-Laserlicht und optional einen mineralischen Füllstoff enthält.

Überraschenderweise wurde gefunden, dass mit Polyvinylalkoholen als Bindemittel in Kombination mit einem auf Kohlenstoff basierenden UV/VIS- und IR-Absorber sehr empfindliche, laserablatierbare Schichten formuliert werden können. Werden diese Schichten bei der Herstellung noch zusätzlich vernetzt, erhält man hochauflösende Maskenfilme, die einfach und sicher handhabbar sind und für eine Vielzahl photolithographischer Prozesse geeignet sind. Dadurch, dass sowohl die Haftschicht als auch die laserablatierbare Schicht wenig oder gar keine niedermolekularen Bestandteile enthalten, findet bei der Belichtung mit UVA-Licht keine wesentliche Migration von Bestandteilen der Maskenschicht in die zu belichtende Druckplatte statt, und der Maskenfilm kann problemlos mehrfach verwendet werden.

Als Polyvinylalkohole bezeichnet man Polymere mit Vinylalkohol-Einheiten, insbesondere partiell oder vollständig verseifte Polyvinylacetate. Vinylacetat-Vinylalkohol-Copolymere sind durch das Molekulargewicht und den Verseifungsgrad (der prozentuale Anteil der Vinylalkohol-Einheiten im Polymer, bezogen auf die Gesamtzahl der Monomereinheiten) gekennzeichnet. Je nach Verseifungsgrad können die Kristallinität der Produkte und deren mechanische Eigenschaften gesteuert werden. Die polare Natur der OH-Gruppen ist ferner für das gute Dispergiervermögen der Polyvinylalkohole verantwortlich. Polyvinylalkohole sind auch aus Sicht der Laserablation gut geeignet. Sie zeigen kein ausgeprägtes Aufschmelzen, sondern zersetzen sich bei Einwirkung hoher Temperaturen - wie sie bei der Laserablation auftreten - rückstandsfrei.

Für die erfindungsgemäße laserablatierbare Maskenschicht werden Polyvinylalkohole mit einem mittleren bis hohen Verseifungsgrad bevorzugt. Bei zu niedrigem Verseifungsgrad sind die Polymere zu weich und zu empfindlich. Bei vollständiger Verseifung sind die Polymere hart und spröde. Die Oberfläche des Maskenfilms kann dann sogar reißen. Im Allgemeinen werden Polyvinylalkohole mit einem Verseifungsgrad von 50% bis maximal 99% verwendet. Bevorzugt werden Polyvinylalkohole mit einem Verseifungsgrad von 60% bis 90% eingesetzt.

Es können auch andere Vinylalkohol-Copolymere wie beispielsweise Poly-(vinylpropionat-vinylalkohol), Poly(vinylacetal-vinylalkohol) und Poly(ethylenvinylalkohol) als Bindemittel der laserablatierbaren Schicht eingesetzt werden, sofern sie mindestens 50 mol-% Vinylalkoholeinheiten enthalten.

Als IR-Absorber für die laserablatierbare Maskenschicht eignen sich insbesondere feinteiliger Ruß, Graphit, Ruß-Nanoröhrchen oder Ruß-Nanopartikel. Ruß hat ein breites Absorptionsspektrum, das sich aus dem sichtbaren Bereich bis in den IR-Bereich erstreckt. Ruß enthaltende Schichten können daher sowohl mit IR-Laserdioden (830 nm) oder Nd-YAG-Festkörper- oder Faserlaser (1064 nm) ablatiert werden. Selbstverständlich kann die laserablatierbare Schicht aber auch andere migrationsstabile IR-Absorber auf Pigmentbasis enthalten. Auf Grund ihrer Fähigkeit zur Migration werden in der laserablatierbaren Schicht aber möglichst keine löslichen, niedermolekularen IR-Farbstoffe oder anderen niedermolekularen Farbstoffe, wie beispielsweise UV-Absorber, eingesetzt.

Die Rußpartikel können oberflächenbehandelt sein. Beispielsweise kann die Ladungsdichte an der Partikeloberfläche durch geeignete Dispergatoren verändert werden, so dass sich besonders feinteilige Rußdispersionen herstellen lassen. Auch niedermolekulare Rußdispergierhilfsmittel können in die Druckplatte migrieren und das Eigenschaftsprofil des laserablatierbaren Maskenfilms verändern. Bei Einsatz derartiger Hilfsmittel muss daher sichergestellt sein, dass die Affinität der Dispergierhilfsmittel zur Oberfläche der Rußpartikel deutlich höher ist als zu den eingesetzten Bindemitteln.

Die Menge der IR-Absorber beträgt in der Regel 5 bis 70 Gew.-%, vorzugsweise 30 bis 60 Gew.-%, bezüglich der Menge aller Komponenten der laserablatierbaren Maskenschicht (iii).

Der Polyvinylalkohol der laserablatierbaren Maskenschicht (iii) wird bei der Herstellung der Maskenschicht (iii) zusätzlich chemisch vernetzt. Unvernetzte Polyvinylalkohol-Ruß-Schichten haben zwar bereits eine ausgezeichnete Laserempfindlichkeit, sind aber gleichzeitig feuchtigkeitsempfindlich. Die Beständigkeit der laserablatierbaren Maskenschicht gegenüber hoher Luftfeuchte wird erheblich verbessert, wenn die Polyvinylalkohole chemisch vernetzt werden. Unvernetzte Polyvinylalkohol-Schichten müssen vorsichtig gehandhabt werden. Zur Vermeidung von Fingerabdrücken auf der laserablatierbaren Maskenschicht empfiehlt sich das Tragen von Handschuhen. Vernetzte Polyvinylalkoholschichten sind dagegen gegenüber Feuchtigkeit und Fingerabdrücken unempfindlich, so dass keine besonderen Maßnahmen bei der Handhabung des Maskenfilms erforderlich sind.

Zur chemischen Vernetzung der Aufzeichnungsschicht auf Basis von Polyvinylalkoholen kommen verschiedene Vernetzer in Betracht, wie mehrfach funktionelle Isocyanate, einfach oder mehrfach funktionelle Aldehyde, mehrfach funktionelle Epoxide, mehrfach funktionelle Carbonsäuren und mehrfach funktionelle Carbonsäureanhydride.

Von den Vernetzungsreaktionen ist insbesondere die Umsetzung von Polyvinylalkoholen mit mehrfach funktionellen Isocyanaten, mehrfach funktionellen Epoxiden oder ein- oder mehrfach funktionellen Aldehyden bevorzugt. Diese Vernetzungsreaktionen laufen bei nicht zu hohen Temperaturen nahezu quantitativ ab. Bevorzugte Vernetzer sind Aldehyde wie Formaldehyd, Acetaldehyd, Propionaldehyd, Butyraldehyd und höhere Aldehyde. Diese Vernetzer haben neben ihrer hohen Reaktivität noch den weiteren Vorteil, dass sie nur aus Kohlenstoff, Sauerstoff und Wasserstoff bestehen. In Verbindung mit Polyvinylalkoholen ergeben sich so Maskenschichten, die bei der Laserablation erheblich weniger toxische Gase freisetzen als Maskenschichten, die Stickstoff-haltige Komponenten enthalten, wie beispielsweise Isocyanate.

Besonders bevorzugt ist die Vernetzung mit bifunktionellen Aldehyden wie beispielsweise Glyoxal und Glutardialdehyd. Diese Aldehyde liegen bereits als wässrige Lösung vor und können daher problemlos wässrigen oder alkoholischen Polyvinylalkohollösungen zugemischt werden. Die Lösungen sind bei Raumtemperatur ausreichend stabil und können daher gut schichtweise aufgetragen werden. Nach der Beschichtung werden die Schichten kurzfristig auf Temperaturen von 90 °C bis 120 °C erwärmt. Dabei reagieren die OH-Gruppen des Polyvinylalkohols mit den Aldehydfunktionen zu Acetalen. Werden bifunktionelle Aldehyde eingesetzt, kommt es zur Vernetzung des Polyvinylalkohols. Die Vernetzungsreaktion kann durch Zugabe von Säure beschleunigt werden.

Der Vernetzer wird der laserablatierbaren Maskenschicht (iii) im Allgemeinen in Mengen von 1 Gew.-% bis maximal 20 Gew.-%, bezüglich der Menge aller Komponenten der Schicht, zugefügt. Bevorzugt ist ein Anteil von 1 bis 10 Gew.-% Vernetzer. Die Menge an Polyvinylalkohol beträgt, bezogen auf alle Komponenten der laserablatierbaren Maskenschicht, im Allgemeinen 20 bis 50 Gew.-%. Die Menge an Vernetzer beträgt somit 2 bis 40 Gew.-Teile, bevorzugt 2 bis 20 Gew.-Teile, bezogen auf 100 Gew.-Teile des Polyvinylalkohols. Die Menge an vernetztem Polyvinylalkohol a) beträgt somit im Allgemeinen 21 bis 70 Gew.-%, bezogen auf die Summe aller Komponenten a) bis c) der laserablatierbaren Maskenschicht.

Optional kann die laserablatierbare Schicht (iii) noch einen mineralischen Füllstoff enthalten. Ähnlich wie in der Haftschicht kann ein zusätzlicher Füllstoff als Abstandshalter fungieren und den Kontakt zur Druckplatte bei der UV-Belichtung verbessern und so das Risiko von Hohlkopien vermindern.

Als Füllstoffe kommen insbesondere anorganische Füllstoffe und Pigmente in Frage. Besonders geeignete Füllstoffe sind beispielsweise Siliciumdioxid, insbesondere Quarzmehle und Quarzpulver, Silikate, insbesondere Aluminiumsilikate, Silikatgläser, Aluminium-, Eisen- oder Chromoxide.

Der mittlere Teilchendurchmesser der anorganischen Füllstoffe beträgt in der Regel 0,1 bis 6 µm und kann damit auch größer sein als die Dicke der laserablatierbaren Schicht (siehe unten) oder größer sein als die mittlere Teilchengröße der eingesetzten Rußpartikel. Dies ist eine Voraussetzung dafür, dass die Füllstoffteilchen aus der Schicht herausragen und überhaupt als mechanische Abstandshalter fungieren können. Die Form der Füllstoffe ist beliebig. Die meisten aufgeführten Füllstoffe bilden keine runden Partikel, sondern weisen beliebige kristalline Formen auf. Die Füllstoffe können oberflächenbehandelt sein oder beschichtet, um besonders gut in der polymeren Matrix dispergiert zu werden.

Der Anteil des mineralischen Füllstoffes in der laserablatierbaren Maskenschicht (iii) beträgt im Allgemeinen 0 bis 30 Gew.-%, bezogen auf alle Komponenten der Maskenschicht (iii). Wird ein anorganischer Füllstoff mitverwendet, dann wird er im Allgemeinen in einer Menge von 5 bis 30 Gew.-%, bezogen auf die Summe aller Komponenten a) bis c) der Maskenschicht, mitverwendet.

Die laserablatierbare Maskenschicht (iii) enthält im Allgemeinen
a) 21 bis 70 Gew.-% des Bindemittels enthaltend einen vernetzten Polyvinylalkohol,
b) 5 bis 70 Gew.-% des UV/VIS- und IR-Licht absorbierenden Materials und
c) 0 bis 30 Gew.-% des anorganischen Füllstoffs.

Die Dicke der laserablatierbaren Maskenschicht (iii) beträgt im Allgemeinen von 1 µm bis 10 µm, bevorzugt von 2 µm bis 6 µm. Bei geringeren Schichtdicken ist es schwierig, eine homogene, absolut von Pinholes freie Beschichtung und die notwendige optische Dichte zu erreichen. Bei höheren Schichtdicken ist die Laserempfindlichkeit zu gering und die Laserzeit wird zu lang. Ferner können dann Streueffekte bei der UV-Belichtung auftreten, die die Klischeequalität verschlechtern. Die optische Dichte des Maskenfilms im Bereich der UVA-Strahlung sollte mindestens 2,5, bevorzugt mindestens 3 Einheiten betragen. Der UVA-Strahlungsbereich umfasst Licht der Wellenlänge von 300 bis 400 nm. Die optische Dichte ist die logarithmische Maßzahl für die Lichtundurchlässigkeit der Schicht in diesem Wellenlängenbereich. Bei der Messung der optischen Dichte wird daher kein Einzelwert der Lichtundurchlässigkeit bei einer bestimmten Wellenlänge ermittelt, sondern ein Mittelwert der Lichtundurchlässigkeiten in einem definierten Wellenlängenbereich. Üblicherweise erfolgt die Messung der optischen Dichte mittels kommerziell verfügbarer Densitometer (z.B. von x-rite), wobei der Wellenlängenbereich vor der Messung ausgewählt wird. Im Sinne der Erfindung beziehen sich alle zitierten Messwerte der optischen Dichte auf den UVA-Bereich, d.h. den Bereich von 300 bis 400 nm.

Natürlich können die Primerschicht (ii) und die laserablatierbare Maskenschicht (iii) noch weitere Komponenten wie Weichmacher, Verlaufshilfsmittel, Gleitmittel oder andere oberflächenaktive Substanzen enthalten. Auf Grund der geschilderten Migrationsproblematik sollte der Anteil niedermolekularer Komponenten in beiden Schichten in der Summe aber weniger als 10 Gew.-%, bevorzugt weniger als 5 Gew.-% betragen. Niedermolekulare Komponenten, die in die zu belichtende Druckplatte migrieren können, haben ein Molekulargewicht von weniger als 1000g/mol. Dies bedeutet also, dass die erfindungsgemäßen laserablatierbaren Maskenfilme mindestens 90 Gew.-% bevorzugt mindestens 95 Gew.-% an Komponenten mit einem Molekulargewicht von > 1000 g/mol enthalten müssen.

Die einzelnen Schichten der erfindungsgemäßen Maskenfilme können in beliebiger Weise durch Gießen, Sprühen, Walzen oder Rakelverfahren aufgebracht werden.

Zunächst wird die Haftschicht (ii) auf die Polyesterfolie aufgetragen. Dabei liegen die Komponenten der Haftschicht (ii) üblicherweise in organischen Lösungsmitteln gelöst vor. Geeignete organische Lösemittel sind beispielsweise Ethylacetat oder Methylethylketon (MEK). Wird ein 2-Komponentensystem aufgetragen, wird der Vernetzer der Beschichtungslösung kurz vor der Beschichtung zugesetzt. Nach dem Auftrag wird die Haftschicht getrocknet, wobei die Trocknungstemperatur und die Verweilzeit so gewählt werden, dass der Vernetzer mit der polymeren Komponente quantitativ abreagiert.

Anschließend wird die laserablatierbare Maskenschicht (iii) aufgetragen. Hierzu wird der Polyvinylalkohol in Wasser oder Wasser/Alkoholgemischen gelöst und anschließend die Ruß-Komponente portionsweise zugegeben. Die Lösung wird dann mehrere Stunden über eine Kugelmühle gefahren, wodurch eine feine Dispergierung des Rußes erreicht wird. Anschließend werden die übrigen Komponenten der laserablatierbaren Schicht zugefügt. Die Lösung wird dann in einem oder mehreren Schritten auf die mit der Haftschicht beschichtete PET-Folie aufgetragen und anschließend getrocknet. Bei der Trocknung wird die Aufzeichnungsschicht kurzzeitig auf Temperaturen im Bereich von 90 bis 120 °C erhitzt, wobei der Polyvinylalkohol mit dem Vernetzer abreagiert. Wird als Vernetzer Glyoxal verwendet, dann liegen die notwendigen Trocknungszeiten bzw. Reaktionszeiten bei ca. 100 °C im Bereich einiger weniger Sekunden.

Abhängig vom verwendeten Laser können die erfindungsgemäßen Maskenfilme bis zu einer Auflösung von 10 000 dpi digital bebildert (gelasert) werden. Geeignete Lasersysteme sind beispielsweise Laser der Baureihe CDI oder CDI Spark von Esko Graphics. Diese Laser arbeiten bei einer Wellenlänge von 1064 nm bzw. 1070 nm und verfügen über einen passenden Energieeintrag. Alternativ können die Maskenfilme auch mit Diodenlasern (830 nm) digital bebildert werden, sofern die notwendige Laserenergie eingebracht werden kann. Die zur Ablation der erfindungsgemäßen Maskenfilme benötigte Energie beträgt im Allgemeinen von 3 bis 5 J/cm².

Zur Bebilderung mittels Laserablation werden die Maskenfilme auf die Trommel des Lasers eingespannt. Die notwendige Laserenergie wird durch Messen der optischen Dichte bei vollständiger Ablation einer Fläche ermittelt. Bei korrekter Einstellung sollte diese ODₘᵢₙ < als 0,2, bevorzugt 0,1 Einheiten betragen. Zur Bestimmung der notwendigen Laserenergie werden verschiedene Flächen mit unterschiedlicher Energie ablatiert. Die freigelaserten Flächen müssen für das UV-Licht möglichst transparent sein. Eine optische Dichte von 0,1 bedeutet, dass der Film 90% des UV-Lichtes durchlässt. Die Fläche ist also korrekt freigelasert.

Gegenstand der Erfindung ist auch ein Verfahren zur Herstellung eines Flexodruckklischees, umfassend die Schritte:
(i) Digitale Bebilderung durch Laserablation des erfindungsgemäßen Maskenfilms,
(ii) Auflegen oder Auflaminieren des digital bebilderten Maskenfilms auf die zu belichtende Flexodruckplatte,
(iii) Belichten der reliefbildenden Schicht der Druckplatte mit UVA-Licht durch den digital bebilderten Maskenfilm hindurch,
(iv) Entfernen des Maskenfilms,
(v) Entwicklung der Reliefs durch Entfernen der nicht polymerisierten Anteile der reliefbildenden Schicht mit einem Auswaschmittel oder durch thermische Entwicklung,
(vi) optional Trocknung des erhaltenen Flexodruckklischees,
(vii) optional Nachbehandlung des Flexodruckklischees mit UVA- oder UVC-Licht.

Gegenstand der Erfindung ist auch die Verwendung der erfindungsgemäßen Maskenfilme zur Belichtung von Reliefdruckplatten und Siebdruckschablonen.

Gegenstand der Erfindung ist auch die Verwendung der erfindungsgemäßen Maskenfilme zur Herstellung von Korrekturfilmen.

### Beispiel

Eine 175 µm dicke PET-Folie vom Typ Melinex® OD wurde mit einer Haftschicht (Primerschicht) beschichtet. Die Zusammensetzung der Primerschicht ist in Tabelle 1 wiedergegeben.

**Tabelle 1**

| Komponente | Chemie / Funktion | Hersteller | Anteil fest (Gew.-%) |
|---|---|---|---|
| Desmocoll® 400/1 | PUR / Bindemittel | Bayer | 82 |
| Desmodur® RN | Isocyanat / Vernetzer | Bayer | 10 |
| Syloid® ED3 | Silikat / Füllstoff | Degussa | 8 |
| Summe | | | 100 |

Das Bindemittel der Primerschicht wurde in Ethylacetat gelöst. Anschließend wurde der Füllstoff zugegeben und die Dispersion 2 h lang gerührt. Kurz vor der Beschichtung wurde der Vernetzer hinzugefügt und der Feststoffgehalt der Mischung mittels Zugabe von Ethylacetat auf 3 Gew.-% eingestellt. Die Lösung wurde auf einer Beschichtungsanlage im Dosierwalzenauftragsverfahren bei einer Bahngeschwindigkeit von 10 m/min aufgetragen. Anschließend wurde die Schicht bei 105 °C getrocknet (Trockenkanallänge: 9 m). Nach der Trocknung betrug das Auftragsgewicht 1,2 g/m². In der Schicht konnte kein freies Isocyanat nachgewiesen werden.

Die mit dem Primer beschichtete PET-Folie wurde anschließend mit der laserablatierbaren Maskenschicht überschichtet. Die Zusammensetzung dieser Schicht ist in Tabelle 2 wiedergegeben.

**Tabelle 2**

| Komponente | Chemie / Funktion | Hersteller | Anteil fest (Gew.%) |
|---|---|---|---|
| Alcotex® 72.5 | PVA / Bindemittel | Kuraray | 65,2 |
| Levanyl® Schwarz A-SF | Rußdispersion / IR-Absorber | Lanxess | 30,0 |
| Syloid® ED3 | Silikat / Füllstoff | Degussa | 2,0 |
| Glyoxal | Vernetzer | BASF | 2,8 |
| Summe | | | 100 |

Zur Herstellung der Gießlösung wurde der Polyvinylalkohol in einer Mischung aus Wasser/n-Propanol (3/1) gelöst. Danach wurden die Rußdispersion und der Füllstoff portionsweise eingerührt und die Mischung 2 h über eine Kugelmühle gefahren. Kurz vor dem Beschichten wurde das Glyoxal zugesetzt, der Feststoffgehalt durch Verdünnen auf 8,2 Gew.-% eingestellt und der pH-Wert durch Zugabe von 7 gew.-%iger Salzsäure auf 4 eingestellt.

Die Lösung wurde auf einer Beschichtungsanlage im Dosierwalzenauftragsverfahren bei einer Bahngeschwindigkeit von 10 m/min aufgetragen. Anschließend wurde die Schicht wiederum bei 105 °C getrocknet (Trockenkanallänge 9 m). Nach der Trocknung betrug das Auftragsgewicht 5,0 +/- 0,2 g/m² (gemessen jeweils im Abstand von 10 cm über die gesamte Beschichtungsbreite von 1,2 m). In der getrockneten Schicht konnte kein Glyoxal mehr nachgewiesen werden. Die Beschichtung war absolut fehlerfrei. Es konnten keinerlei Pinholes oder Beschichtungsfehler festgestellt werden. Die optische Dichte der Beschichtung (wiederum gemessen im Abstand von jeweils 10 cm über die gesamte Beschichtungsbreite) lag zwischen 4,9 und 5,0.

Nach einer Lagerzeit von 2 Wochen wurde der hergestellte Maskenfilm auf einem Esko-Laser (CDI Spark 4835) mit einer Auflösung von 4000 dpi mit einem nyloflex Testmotiv (Flint Group) bebildert. Das Testmotiv umfasste unter anderem einen Rasterkeil mit Tonwerten von 1% bis 100% bei einer Linienweite von 47 L/cm.

Der Film wurde auf die Trommel des Lasers montiert und mit einer Energie von 4,5 J/cm² ablatiert. Die Handhabung des Films war problemlos. Auch bei Handhabung ohne Schutzhandschuhe konnten keine Abdrücke oder sonstige Beschädigungen auf dem Maskenfilm festgestellt werden. Die freigelaserte Vollfläche hatte eine optische Dichte von 0,1. Die ablatierten Elemente des Maskenfilms waren allesamt randscharf abgebildet.

Mit dem ablatierten Maskenfilm wurde eine Flexodruckplatte (nyloflex ACE 114, Flint Group) hergestellt. Die Deckfolie wurde von der Druckplatte abgezogen. Der ablatierte Maskenfilm wurde mit der Schichtseite auf die Druckplattenoberfläche aufgelegt und mit einer Vakuumfolie in einem nyloflex FIII-Belichter (Flint Group) fixiert. Anschließend wurde die Druckplatte durch den Maskenfilm 14 Minuten mit UVA-Strahlung belichtet. Nach der Belichtung wurde der Maskenfilm von der Druckplatte abgezogen. Danach wurde die Flexoplatte mittels eines handelsüblichen organischen Auswaschmittels (nylosolv® A, Flint Group) in einem nyloflex F III-Auswaschgerät (Flint Group) mit einer Durchlaufzeit von 240 mm/min ausgewaschen. Nach dem Auswaschprozess wurde die Druckplatte 90 Minuten bei 60 °C getrocknet und anschließend mit UVA- und UVC-Licht nachbehandelt. Das Klischee wurde mikroskopisch untersucht. Die Rasterpunkte des 1% Tonwerts waren auf dem Klischee einwandfrei abgebildet.

Mit demselben Maskenfilm wurden 10 weitere Flexodruckplatten belichtet und weiterverarbeitet. Die Qualität der hergestellten Klischees war identisch. Es konnten keinerlei Abweichungen bei den Dimensionen der typischen Testelemente eines Flexoklischees (1% positiver Rasterpunkt, Zwischentiefe im 200 µm Negativpunkt, 50 µm positive Gitterlinien) festgestellt werden.

## Patentansprüche

1. Laserablatierbarer Maskenfilm für die Belichtung von Reliefdruckplatten und Siebdruckschablonen umfassend mindestens
(i) eine dimensionsstabile Trägerfolie,
(ii) eine UV-transparente Haftschicht und
(iii) eine laserablatierbare Maskenschicht,
**dadurch gekennzeichnet, dass** die laserablatierbare Maskenschicht (iii)
a) ein Bindemittel enthaltend einen vernetzten Polyvinylalkohol,
b) ein UV/VIS- und IR-Licht absorbierendes Material und
c) optional einen anorganischen Füllstoff
enthält.

2. Laserablatierbarer Maskenfilm nach Anspruch 1, **dadurch gekennzeichnet, dass** der Polyvinylalkohol des Bindemittels a) ein teilverseiftes Polyvinylacetat mit einem Verseifungsgrad von 50 bis 99 mol-% ist.

3. Laserablatierbarer Maskenfim nach Anspruch 1 oder 2, **dadurch gekennzeichnet, dass** der Polyvinylakohol des Bindemittels a) mit Glyoxal oder Glutardialdehyd vernetzt ist.

4. Laserablatierbarer Maskenfilm nach einem der Ansprüche 1 bis 3, **dadurch gekennzeichnet, dass** die laserablatierbare Maskenschicht (iii) eine optische Dichte von > 2,5 aufweist.

5. Laserablatierbarer Maskenfilm nach einem der Ansprüche 1 bis 4, **dadurch gekennzeichnet, dass** das UV/VIS- und IR-Licht absorbierende Material b) ausgewählt ist aus der Gruppe bestehend aus Ruß, Graphit, Kohlenstoff-Nanoröhren und Kohlenstoff-Nanopartikeln.

6. Laserablatierbarer Maskenfilm nach einem der Ansprüche 1 bis 5, **dadurch gekennzeichnet, dass** die laserablatierbare Maskenschicht (iii)
a) 21 bis 70 Gew.-% des Bindemittels enthaltend einen vernetzten Polyvinylalkohol,
b) 5 bis 70 Gew.-% des UV/VIS- und IR-Licht absorbierenden Materials und
c) 0 bis 30 Gew.-% des anorganischen Füllstoffs enthält.

7. Laserablatierbarer Maskenfilm nach einem der Ansprüche 1 bis 6, **dadurch gekennzeichnet, dass** der vernetzte Polyvinylalkohol mit 2 bis 40 Gewichtsteilen Vernetzer, bezogen auf 100 Gewichtsteile Polyvinylalkohol, vernetzt ist.

8. Laserablatierbarer Maskenfilm nach einem der Ansprüche 1 bis 7, **dadurch gekennzeichnet, dass** die laserablatierbare Maskenschicht (iii)
c) 5 bis 30 Gew.-% des anorganischen Füllstoffs
enthält.

9. Laserablatierbarer Maskenfilm nach einem der Ansprüche 1 bis 8, **dadurch gekennzeichnet, dass** die Haftschicht (ii)
d) 70 bis 100 Gew.-% eines polymeren Bindemittels,
e) 0 bis 30 Gew.-% eines Vernetzers,
f) 0 bis 30 Gew.-% eines anorganischen Füllstoffs
enthält.

10. Laserablatierbarer Maskenfilm nach Anspruch 9, **dadurch gekennzeichnet, dass** das polymere Bindemittel d) ausgewählt ist aus der Gruppe bestehend aus Polyestern, Polyetherestern, Polyurethanen und Polyesterurethanen.

11. Laserablatierbarer Maskenfilm nach Anspruch 9 oder 10, **dadurch gekennzeichnet, dass** das polymere Bindemittel d) ein OH-Gruppen enthaltendes Polymer ist, das mit einem multifunktionellen Isocyanat als Vernetzer e) vernetzt ist.

12. Verfahren zur Herstellung eines Flexodruckklischees, umfassend die Schritte
(i) Digitale Bebilderung durch Laserablation eines Maskenfilms, wie er in einem der Ansprüche 1 bis 11 definiert ist,
(ii) Auflegen oder Auflaminieren des digital bebilderten Maskenfilms auf die zu belichtende Flexodruckplatte,
(iii) Belichten der reliefbildenden Schicht der Druckplatte mit UVA-Licht durch den digital bebilderten Maskenfilm hindurch,
(iv) Entfernen des Maskenfilms,
(v) Entwicklung des Reliefs durch Entfernen der nicht polymerisierten Anteile der reliefbildenden Schicht mit einem Auswaschmittel oder durch thermische Entwicklung,
(vi) optional Trocknung des erhaltenen Flexodruckklischees,
(vii) optional Nachbehandlung des Flexodruckklischees mit UVA- oder UVC-Licht.

13. Verwendung eines laserablatierbaren Maskenfilms, wie in einem der Ansprüche 1 bis 11 definiert, zur Belichtung von Reliefdruckplatten und Siebdruckschablonen.

14. Verwendung eines laserablatierbaren Maskenfilms, wie in einem der Ansprüche 1 bis 11 definiert, zur Herstellung von Korrekturfilmen.

## Claims

1. Laser-ablatable mask film for the exposure of relief printing plates and screen printing stencils, comprising at least
(i) a dimensionally stable base sheet,
(ii) a UV-transparent adhesion layer, and
(iii) a laser-ablatable mask layer,
**characterized in that** the laser-ablatable mask layer (iii) comprises
a) a binder comprising a crosslinked polyvinyl alcohol,
b) a material which absorbs UV/VIS light and IR light, and
c) optionally an inorganic filler.

2. Laser-ablatable mask film according to Claim 1, **characterized in that** the polyvinyl alcohol of the binder a) is a partially hydrolyzed polyvinyl acetate having a degree of hydrolysis of 50 to 99 mol%.

3. Laser-ablatable mask film according to Claim 1 or 2, **characterized in that** the polyvinyl alcohol of the binder a) is crosslinked with glyoxal or glutaraldehyde.

4. Laser-ablatable mask film according to any of Claims 1 to 3, **characterized in that** the laser-ablatable mask layer (iii) has an optical density of > 2.5.

5. Laser-ablatable mask film according to any of Claims 1 to 4, **characterized in that** the material b) which absorbs UV/VIS light and IR light is selected from the group consisting of carbon black, graphite, carbon nanotubes, and carbon nanoparticles.

6. Laser-ablatable mask film according to any of Claims 1 to 5, **characterized in that** the laser-ablatable mask layer (iii) comprises
a) 21 to 70 wt% of the binder comprising a crosslinked polyvinyl alcohol,
b) 5 to 70 wt% of the material which absorbs UV/VIS light and IR light, and
c) 0 to 30 wt% of the inorganic filler.

7. Laser-ablatable mask film according to any of Claims 1 to 6, **characterized in that** the crosslinked polyvinyl alcohol is crosslinked with 2 to 40 parts by weight of crosslinker per 100 parts by weight of polyvinyl alcohol.

8. Laser-ablatable mask film according to any of Claims 1 to 7, **characterized in that** the laser-ablatable mask layer (iii) comprises
c) 5 to 30 wt% of the inorganic filler.

9. Laser-ablatable mask film according to any of Claims 1 to 8, **characterized in that** the adhesion layer (ii) comprises
d) 70 to 100 wt% of a polymeric binder,
e) 0 to 30 wt% of a crosslinker,
f) 0 to 30 wt% of an inorganic filler.

10. Laser-ablatable mask film according to Claim 9, **characterized in that** the polymeric binder d) is selected from the group consisting of polyesters, polyetheresters, polyurethanes, and polyesterurethanes.

11. Laser-ablatable mask film according to Claim 9 or 10, **characterized in that** the polymeric binder d) is a polymer which contains OH groups and which is crosslinked with a polyfunctional isocyanate as crosslinker e).

12. Method for producing a flexographic cliche, comprising the steps of
(i) digital imaging by laser ablation of a mask film as defined in any of Claims 1 to 11,
(ii) placement or lamination of the digitally imaged mask film onto the flexographic printing plate that is to be exposed,
(iii) exposure of the relief-forming layer of the printing plate with UVA light through the digitally imaged mask film,
(iv) removal of the mask film,
(v) development of the relief by removal of the unpolymerized portions of the relief-forming layer with a washout medium or by thermal development,
(vi) optionally, drying of the resulting flexographic cliché,
(vii) optionally, aftertreatment of the flexographic cliché with UVA or UVC light.

13. Use of a laser-ablatable mask film as defined in any of Claims 1 to 11 for exposure of relief printing plates and screen printing stencils.

14. Use of a laser-ablatable mask film as defined in any of Claims 1 to 11 for production of correction films.

## Revendications

1. Film de masquage amovible par ablation laser pour l'exposition de plaques d'impression en relief et de pochoirs de sérigraphie, comprenant au moins :
(i) un film support de dimensions stables,
(ii) une couche adhésive transparente aux UV et
(iii) une couche de masquage amovible par ablation laser,
**caractérisé en ce que** la couche de masquage amovible par ablation laser (iii) contient :
a) un liant contenant un alcool polyvinylique réticulé,
b) un matériau absorbant la lumière UV/VIS et IR, et
c) éventuellement une charge inorganique.

2. Film de masquage amovible par ablation laser selon la revendication 1, **caractérisé en ce que** l'alcool polyvinylique du liant a) est un polyacétate de vinyle partiellement saponifié ayant un degré de saponification de 50 à 99 % en moles.

3. Film de masquage amovible par ablation laser selon la revendication 1 ou 2, **caractérisé en ce que** l'alcool polyvinylique du liant a) est réticulé avec du glyoxal ou du glutardialdéhyde.

4. Film de masquage amovible par ablation laser selon l'une quelconque des revendications 1 à 3, **caractérisé en ce que** la couche de masquage amovible par ablation laser (iii) présente une densité optique > 2,5.

5. Film de masquage amovible par ablation laser selon l'une quelconque des revendications 1 à 4, **caractérisé en ce que** le matériau absorbant la lumière UV/VIS et IR b) est choisi dans le groupe constitué par le noir de carbone, le graphite, les nanotubes de carbone et les nanoparticules de carbone.

6. Film de masquage amovible par ablation laser selon l'une quelconque des revendications 1 à 5, **caractérisé en ce que** la couche de masquage amovible par ablation laser (iii) contient :
a) 21 à 70 % en poids du liant contenant un alcool polyvinylique réticulé,
b) 5 à 70 % en poids du matériau absorbant la lumière UV/VIS et IR, et
c) 0 à 30 % en poids de la charge inorganique.

7. Film de masquage amovible par ablation laser selon l'une quelconque des revendications 1 à 6, **caractérisé en ce que** l'alcool polyvinylique réticulé est réticulé avec 2 à 40 parties en poids d'agent de réticulation, par rapport à 100 parties en poids d'alcool polyvinylique.

8. Film de masquage amovible par ablation laser selon l'une quelconque des revendications 1 à 7, **caractérisé en ce que** la couche de masquage amovible par ablation laser (iii) contient :
c) 5 à 30 % en poids de la charge inorganique.

9. Film de masquage amovible par ablation laser selon l'une quelconque des revendications 1 à 8, **caractérisé en ce que** la couche adhésive (ii) contient :
d) 70 à 100 % en poids d'un liant polymère,
e) 0 à 30 % en poids d'un agent de réticulation,
f) 0 à 30 % en poids d'une charge inorganique.

10. Film de masquage amovible par ablation laser selon la revendication 9, **caractérisé en ce que** le liant polymère d) est choisi dans le groupe constitué par les polyesters, les polyéther-esters, les polyuréthanes et les polyester-uréthanes.

11. Film de masquage amovible par ablation laser selon la revendication 9 ou 10, **caractérisé en ce que** le liant polymère d) est un polymère contenant des groupes OH, qui est réticulé avec un isocyanate multifonctionnel en tant qu'agent de réticulation e).

12. Procédé de fabrication d'un cliché de flexographie, comprenant les étapes suivantes :
(i) la formation d'une image numérique par ablation laser d'un film de masquage, tel que défini dans l'une quelconque des revendications 1 à 11,
(ii) la pose ou la stratification du film de masquage imagé numériquement sur la plaque de flexographie à exposer,
(iii) l'exposition de la couche formant un relief de la plaque d'impression à de la lumière UVA au travers du film de masquage imagé numériquement,
(iv) l'élimination du film de masquage,
(v) le développement du relief par élimination des fractions non polymérisées de la couche formant un relief avec un agent de lavage ou par développement thermique,
(vi) éventuellement le séchage du cliché de flexographie obtenu,
(vii) éventuellement le traitement secondaire du cliché de flexographie avec de la lumière UVA ou UVC.

13. Utilisation d'un film de masquage amovible par ablation laser, tel que défini dans l'une quelconque des revendications 1 à 11, pour l'exposition de plaques d'impression en relief et de pochoirs de sérigraphie.

14. Utilisation d'un film de masquage amovible par ablation laser, tel que défini dans l'une quelconque des revendications 1 à 11, pour la fabrication de films de correction.
